# EUROPEAN PATENT SPECIFICATION

(11) **EP 0 202 333 B1**
(45) Date of publication and mention of the grant of the patent: **27.07.1994**
(21) Application number: 86900688.2
(22) Date of filing: 12.11.1985
(51) Int. Cl.: H01B 7/34, H05K 9/00, D03D 15/00, D04B 1/00, D04C 1/00, D04H 1/00

(54) **SHIELDING FABRIC AND ARTICLE**
ABSCHIRMGEWEBE UND ERZEUGNIS
TISSU ET ARTICLE DE BLINDAGE

(30) Priority: 13.11.1984 US 670698; 17.05.1985 US 735883
(43) Date of publication of application: 26.11.1986
(73) Proprietor: THE BENTLEY-HARRIS MANUFACTURING CO., Lionville, Pennsylvania 19353 (US)
(72) Inventor: GLADFELTER, Harry, F., Phoenixville, PA 19460 (US); CONAGHAN, Thomas, B., Rock Hall, MD 21661 (US)
(74) Representative: Crux, John Anthony T&N plc, Group Patent Department
(86) International application number: US8502245
(87) International publication number: WO8603050

(56) References cited:
- EP-A- 0 014 104
- WO-A-85/00556
- US-A- 2 585 054
- US-A- 3 089 915
- US-A- 3 195 395
- US-A- 3 253 618
- US-A- 3 582 445
- US-A- 3 582 532
- US-A- 3 733 213
- US-A- 3 877 965
- US-A- 3 946 143
- US-A- 3 986 530
- US-A- 4 016 356
- US-A- 4 042 737
- US-A- 4 232 082
- US-A- 4 247 596
- US-A- 4 281 211
- US-A- 4 296 855
- US-A- 4 362 779
- US-A- 4 375 009
- US-A- 4 409 427
- US-A- 4 471 015

## Description

This invention relates to shielding of electrical conductors or other substrates from electromagnetic interference (EMI) and radio frequency interference (RFI) by providing a fabric which has effective shielding properties and providing a wraparound tubular article which has effective shielding properties.

RFI/EMI shielding of electrical conductors, cables and other components have conventionally been provided by wire overbraid, metal foils, metallised fabrics, and the like. Typical of such shielding are US-A-3,946,143, US-A-4,016,356; US-A-3,423,515, US-A-3,089,915, US-A-3,582,532 and US-A-4,409,417. The disclosures of the above patents are incorporated herein by reference.

The metallised fabrics referred to in US-A-4,409,427 are typically made by electroless plating or coating of plastic or non-conductive fibres as exemplified by US-A-3,733,213, US-A-3,877,965 and US-A-4,247,596, the disclosures of which are incorporated herein by reference. The conductive fibres of US-A-3,877,965 and others have been used in very low proportions such as from 0.005% to 10% by weight in various fabrics such as carpets to help prevent static electricity build-up.

This invention provides a textile fabric for electrical shielding comprising a fabric which is woven from a yarn comprising conductive fibres and non-conductive organic fibres, characterised in that the conductive fibres comprise non-conductive organic fibres which are plated, coated or impregnated with a conductive material and comprise between about 15% and about 80% by weight of the fabric, the fabric comprising warp yarns in which the conductive fibres constitute between about 20% and about 80% by weight of the yarn and filling yarns in which the conductive fibres constitute between about 1% and about 20% by weight of the yarn.

The non-conductive organic fibres useful in this invention include any non-conductive natural or synthetic fibres such as cotton, wool, silk, cellulose, polyester, polyamide, nylon, and the like. Nylon and/or polyester fibres are particularly preferred. The conductive fibres useful in this invention include conductive fibres made from carbon, graphite or a conductive polymer or non-conductive fibres which can be plated, coated or impregnated with a conductive material and which are able to retain that material for the length of time and under the service conditions to be encountered by the shielding fabric. Depending on the durability, end use and other desirable properties for the shielding article made from the fabric, any combination of conductive and non-conductive fibres may be used. The conductive material plated, coated or impregnated on or in the fibre may be a metal, carbon, and the like. Some preferred conductive fibres include nylon plated with silver or copper, and polyester plated with silver, copper, nickel or tin.

As previously stated, the fabrics of this invention are made from yarns which comprise a blend of conductive and non-conductive fibres of the above-mentioned types wherein the conductive fibres comprise between about 15% and about 80% by weight of the fabric. Preferably, the fabric should comprise between about 15% and about 70% by weight conductive fibres and most preferably between about 20% and about 60%. The yarns useful in this invention comprise a blend of conductive and non-conductive fibres wherein the conductive fibres comprise between about 20% and about 80% by weight of the yarn, except where the yarn is a second yarn in the fabric, such as the filling, the yarn may comprise as low as about 1% by weight conductive fibre. Preferably the yarn should comprise between about 30% and about 70% by weight of conductive fibres and more preferably between about 35% and about 65%. Preferably a second yarn in the fabric such as a filling yarn, should comprise between about 1% and about 20% by weight conductive fibres and more preferably between about 3% and about 15%.

Textile fabrics according to the invention may be used in the manufacture of an assembly including a substrate such as an electrical device which is to be shielded. For example, fabric sheets may be used to shield cabinets for electronic equipment, electric terminals and connectors, while tubular shapes may be used to shield conductors and cables, including round or flat, ribbon cables. Various shapes may be made to shield other components.

It is also useful to include in the fabric of this invention a drainwire or ground wire. The drainwire is conveniently incorporated as the warp strand in a woven fabric. More than one drainwire can be used depending on the desired grounding configuration and the shielding effectiveness required. In general one to four drainwires in the warp direction in a tubular article are sufficient. The drainwire may be stranded copper, tinned or silvered copper, or other material useful as a flexible ground wire.

Tubular articles may be made from the fabric of this invention in a wraparound configuration. Closure may be by overlapping the fabric edges which are then held in place by any suitable means. A preferred means of closure for a wraparound tubular article according to this invention is a non-conductive zipper which has been coated or plated with a conductive metal and bonded or fused to the edges of the fabric forming the wraparound. In this respect, the fabric used with a plated non-conductive zipper can contain 100% conductive fibres or yarns. Hook and loop closures coated with metal may be used as the closure means, eg, the VELCRO and HI-MEG products available from Velcro USA, Inc.

A preferred fabric for this use is a woven fabric wherein the warp strands are longitudinal along the length of the wraparound tubular article and the filling runs across the fabric and consequently around the circumference of the wraparound tubular article when the zipper closure is closed. It is believed that warp strands along the length of the wraparound tubular article provide the most direct and straight path to grounding.

The zipper closure may be any conventional interlocking slide fastener with sufficient tape on the edges thereof for uniformly effective attachment to the edges of the fabric sheet. The interlocking elements of the zipper may be spirals or other type of interlocking elements. The zipper closure may be the conventional visible type closure or may be a concealed type zipper that is not visible from the outside of the wraparound tubular article when the zipper is closed. The end product may be supplied in a continuous roll which is cut to any desired length and closed around the cable or cable bundle with a separate slider tool such as those known in the art and illustrated in US-A-1,452,372 or US-A-4,027,369.

### Brief Description of the Drawings

Figure 1 is an illustration of the use of a fabric according to this invention, to make a wraparound tubular article,
Figure 2 shows in graphic form the shielding effectiveness of a tubular article as described in Example 1,
Figure 3 shows in graphic form the shielding effectiveness of a tubular article as described in Example 2,
Figure 4 shows in graphic form the shielding effectiveness of a tubular article as described in Example 3,
Figure 5 shows in graphic form the shielding effectiveness of a tubular article as described in Example 4,
Figure 6 shows in graphic form the shielding effectiveness of a wraparound tubular article as described in Example 5, and
Figure 7 shows in graphic form the shielding effectiveness of a wraparound article as described in Example 6.

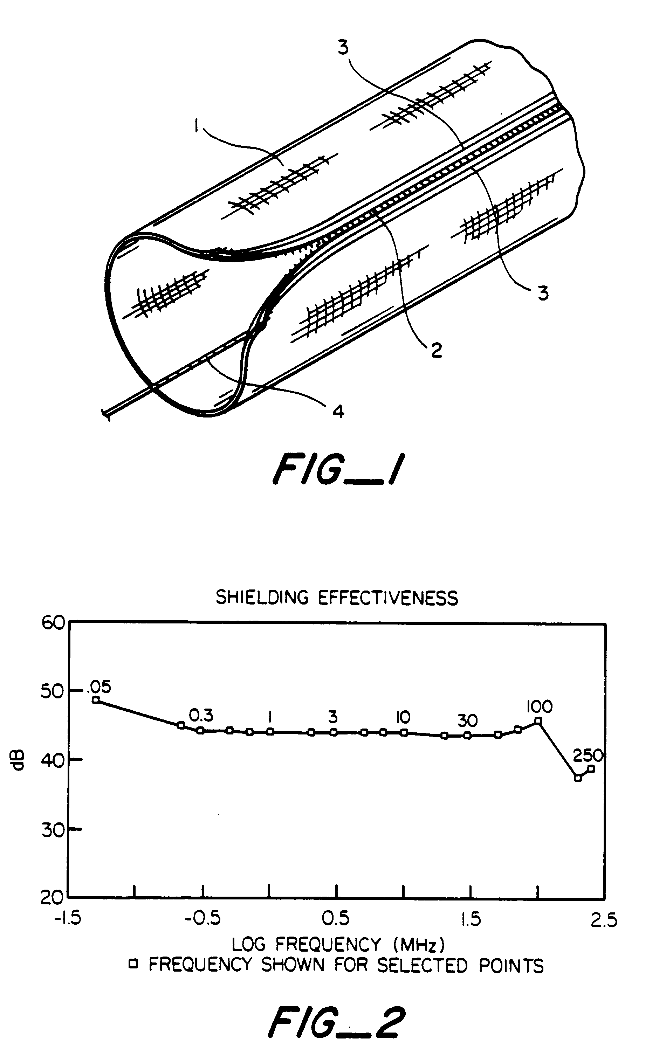

Figure 1 illustrates the use of a fabric according to the invention to make a wraparound tubular article. Fabric sheet 1 has zipper closure 2 attached to opposing edges of the fabric sheet along lines 3. The wraparound tubular article optionally contains a metallic ground strap or drainwire 4 which aids in connecting the wraparound tubular article to a grounding means.

The invention can be further understood by reference to the following Examples. In these Examples, the silver plating on the polyester and nylon yarns was applied by the processes disclosed in US-A-3,877,965.

### EXAMPLE 1

In the Example, a first yarn was prepared from one end of 58 tex (525 denier) multifil nylon yarn having 20% by weight silver plated thereon ("X-Static" yarn from Sauquoit Industries, Inc), which was blended by simply a ply and twist with two ends of 33 tex (300 denier) texturised polyester yarn. The resulting twisted first yarn was 130 tex (1200 denier). A second yarn was prepared from 5.5 (50 denier) tex multifil nylon yarn having 12% silver plated thereon ("X-Static" yarn) twisted with four ends 33 tex (300 denier) texturised polyester. The resulting second yarn was 135 tex (1250 denier). A fabric was woven using the first yarn in the warp and the second yarn in the filling. The fabric was woven in tubular form which when flattened into a tape was 45mm (1.75 inches) wide. The fabric was woven to a density of 20 face ends per cm (50 face ends per inch) and 4.3 face picks per cm (11 face picks per inch). A sample of this tubular article was tested in accordance with NEMA Pub. No. WC 41-1975, Part 3 with a 5 volt input on a sample 0.5m in length. (See also ELECTRI-ONICS, August 1984, pp 35-39.) The shielding effectiveness is depicted in Figure 2 in terms of dB attenuation versus frequency.

### EXAMPLE 2

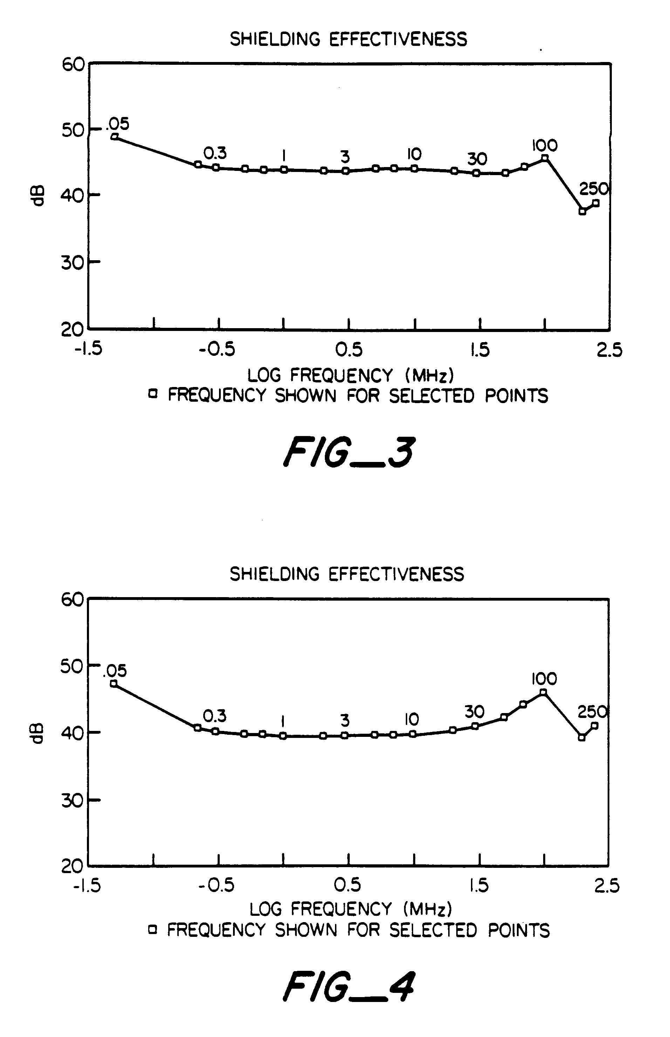

In this Example, a first yarn was prepared as in Example 1 and a second yarn was prepared from spun nylon yarns as follows. A 33 tex (300 denier) spun nylon yarn was made using 4% by weight "X-Static" staple (nylon with 12% silver from Sauquoit Industries) and 96% nylon staple. Two ends of this 33 tex (300 denier) yarn were twisted with one end of 3 tex (27 denier) multifil nylon "X-Static" yarn (12% silver) to give a 70 tex (627 denier) yarn, two ends of which were twisted resulting in a yarn having 139 tex (1254 denier) and 8% by weight conductive fibres. A fabric was prepared as in Example 1 using the first yarn in the warp and the second yarn in the filling. This fabric was formed in a tubular article as in Example 1 and tested in accordance with Example 1. The shielding effectiveness is set forth in graphic form in Figure 3.

### EXAMPLE 3

In this Example, a 56 tex (500 denier) multifil nylon yarn having 12% by weight silver plated thereon was twisted with two ends of a 33 tex (300 denier) texturised polyester producing a twisted first yarn having a total size of 122 tex (1100 denier). The second yarn used in this Example was the same as the second yarn in Example 1. A fabric was woven in accordance with Example 1 using the first yarn in the warp and the second yarn in the fill. The same tubular article was formed and tested in accordance with Example 1. The shielding effectiveness is set forth in graphic form in Figure 4.

### EXAMPLE 4

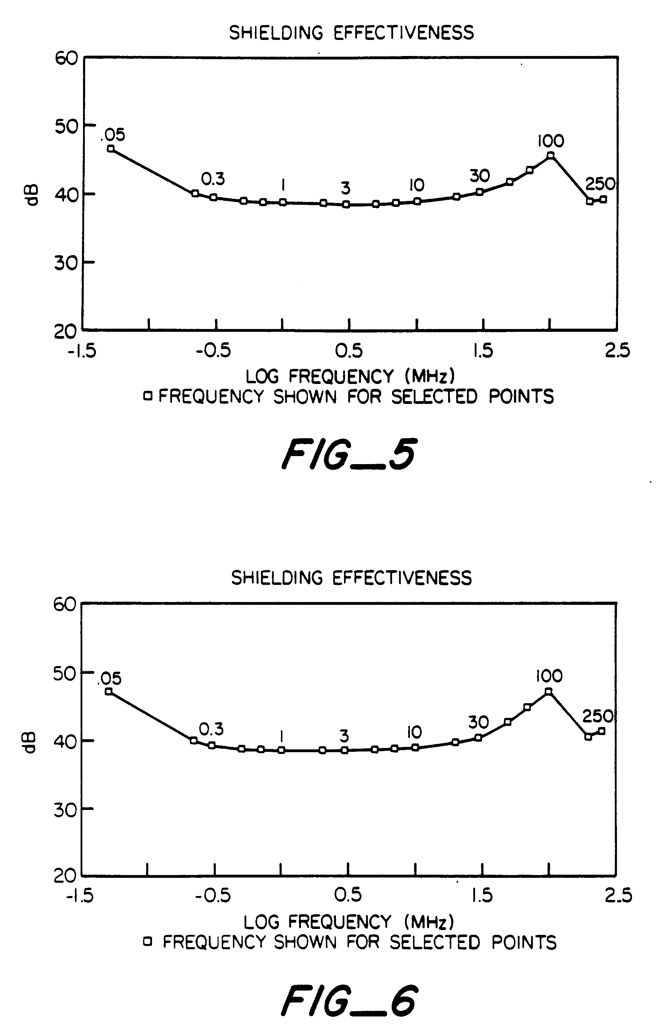

First and second yarns were prepared as in Example 3 and woven into a fabric as in Example 3 except that in the warp two stripes were inserted using a multifil nylon yarn of 126 tex (1130 denier). The nylon yarn was made from one end of 56 tex (500 denier) multifil nylon plated with 12% by weight silver and three ends of 23 tex (210 denier) nylon multifilament which produced a nylon yarn having a total size of 126 tex (1130 denier). Each stripe was 5mm (3/16 inch) wide with 10mm (3/8 inch) between the stripes of nylon. A sample of this tubular article was tested in accordance with Example 1 and the shielding effectiveness is set forth in Figure 5.

### EXAMPLE 5

Example 4 was repeated except that a nylon zipper plated with silver was ultrasonically bonded to the stripes of nylon yarn and the tubular article split under the centre of the zipper to form a wraparound article. This sample was tested as in Example 4 and the shielding effectiveness is set forth in Figure 6.

### EXAMPLE 6

A wraparound tubular shield was made from a nylon fabric having 224 tex (2000 denier) multifilament warp yarn and 0.2mm (8 mil) monofilament weft yarn. The zipper was a size 6 chain, 20mm overall width, all nylon zipper available from American Robbin. The entire fabric sheet and zipper were separately plated with silver using the method of US-A-3,877,965 to 11% by weight silver based on the weight of the finished plated article. The plated zipper was ultrasonically welded to the plated fabric. The wraparound shielding closure was then placed around a 65mm (2.5 inch) wide flat 50-conductor ribbon cable and a 3m length of the wraparound shield was tested in accordance with I.A.W. MIL-STD-285 using the ribbon cable as receiver. The shielding effectiveness is shown in graphic form in Figure 7.

## Claims

1. A textile fabric for electrical shielding comprising a fabric which is woven from a yarn comprising conductive fibres and non-conductive organic fibres, characterised in that the conductive fibres comprise non-conductive organic fibres which are plated, coated or impregnated with a conductive material and comprise between about 15% and about 80% by weight of the fabric, the fabric comprising warp yarns in which the conductive fibres constitute between about 20% and about 80% by weight of the yarn and filling yarns in which the conductive fibres constitute between about 1% and about 20% by weight of the yarn.

2. A fabric according to claim 1 characterised in that the conductive fibres comprise between about 15% and about 70% by weight of the fabric.

3. A fabric according to claim 2 characterised in that the conductive fibres comprise between about 20% and about 60% by weight of the fabric.

4. A fabric according to claim 3 characterised in that the yarns comprise nylon or polyester.

5. A fabric according to claim 4 characterised in that the yarns comprise nylon plated with silver.

6. A fabric according to claim 4 characterised in that the warp yarns comprise between about 30% and about 70% conductive fibres by weight.

7. A fabric according to claim 5 characterised in that the warp yarns comprise between about 30% and about 70% conductive fibres by weight.

8. An article for electrical shielding characterised in that the article is formed at least in part from a fabric according to any of claims 1-7.

9. An article according to claim 8 in the form of a tube.

10. The use of a fabric according to any of claims 1-7 to make an assembly comprising a substrate and the fabric in shielding relationship therewith.

## Patentansprüche

1. Textiles Gewebe zur elektrischen Abschirmung, umfassend ein Gewebe, welches aus einem Garn gewoben ist, welches leitende Fasern und nicht-leitende organische Fasern umfaßt, dadurch gekennzeichnet, daß die leitenden Fasern nicht-leitende organische Fasern umfassen, die mit einem leitenden Material plattiert, überzogen oder imprägniert sind und zwischen etwa 15 Gew.-% und etwa 80 Gew.-% des Gewebes umfassen, wobei das Gewebe Kettgarne, in welchen die leitenden Fasern zwischen etwa 20 Gew.-% und etwa 80 Gew.-% des Garns ausmachen, und Füllgarne, in welchen die leitenden Fasern zwischen etwa 1 Gew.-% und etwa 20 Gew.-% des Garns ausmachen, umfaßt.

2. Gewebe nach Anspruch 1, dadurch gekennzeichnet, daß die leitenden Fasern zwischen etwa 15 Gew.-% und etwa 70 Gew.-% des Gewebes umfassen.

3. Gewebe nach Anspruch 2, dadurch gekennzeichnet, daß die leitenden Fasern zwischen etwa 20 Gew.-% und etwa 60 Gew.-% des Gewebes umfassen.

4. Gewebe nach Anspruch 3, dadurch gekennzeichnet, daß die Garne Nylon oder Polyester umfassen.

5. Gewebe nach Anspruch 4, dadurch gekennzeichnet, daß die Garne mit Silber plattiertes Nylon umfassen.

6. Gewebe nach Anspruch 4, dadurch gekennzeichnet, daß die Kettgarne zwischen etwa 30 Gew.-% und etwa 70 Gew.-% leitende Fasern umfassen.

7. Gewebe nach Anspruch 5, dadurch gekennzeichnet, daß die Kettgarne zwischen etwa 30 Gew.-% und etwa 70 Gew.-% leitende Fasern umfassen.

8. Erzeugnis zum elektrischen Abschirmen, dadurch gekennzeichnet, daß das Erzeugnis zumindest teilweise aus einem Gewebe nach jedem der Ansprüche 1-7 gebildet ist.

9. Erzeugnis nach Anspruch 8 in der Form einer Röhre.

10. Verwendung eines Gewebes nach jedem der Ansprüche 1-7 zur Herstellung eines Gebildes, das ein Substrat und das Gewebe, das mit diesem in einem Abschirmverhältnis steht, umfaßt.

## Revendications

1. Tissu textile pour blindage électrique comprenant un tissu qui est tissé à partir d'un fil comprenant des fibres conductrices et des fibres organiques non conductrices, caractérisé en ce que les fibres conductrices comprennent des fibres organiques non conductrices qui sont plaquées, revêtues ou imprégnées d'une matière conductrice et constituent entre environ 15 % et environ 80 %, en poids, du tissu, le tissu comprenant des fils de chaîne dans lesquels les fibres conductrices constituent entre environ 20 % et environ 80 %, en poids, du fil et des fils de trame dans lesquels les fibres conductrices constituent entre environ 1 % et environ 20 %, en poids, du fil.

2. Tissu selon la revendication 1, caractérisé en ce que les fibres conductrices constituent entre environ 15 % et environ 70 %, en poids, du tissu.

3. Tissu selon la revendication 2, caractérisé en ce que les fibres conductrices constituent entre environ 20 % et environ 60 %, en poids, du tissu.

4. Tissu selon la revendication 3, caractérisé en ce que les fils comprennent du nylon ou du polyester.

5. Tissu selon la revendication 4, caractérisé en ce que les fils comprennent du nylon plaqué avec de l'argent.

6. Tissu selon la revendication 4, caractérisé en ce que les fils de chaîne comprennent entre environ 30 % et environ 70 %, en poids, de fibres conductrices.

7. Tissu selon la revendication 5, caractérisé en ce que les fils de chaîne comprennent entre environ 30 % et environ 70 %, en poids, de fibres conductrices.

8. Article pour blindage électrique caractérisé en ce que l'article est formé, au moins en partie, à partir d'un tissu selon l'une quelconque des revendications 1 à 7.

9. Article selon la revendication 8, ayant la forme d'un tube.

10. Utilisation d'un tissu selon l'une quelconque des revendications 1 à 7 pour fabriquer un ensemble comprenant un substrat et un tissu en relation de blindage avec celui-ci.
